Europäisches Patentamt

European Patent Office

Office européen des brevets

(11) Numéro de publication: **0 430 122 A1**

# (12) DEMANDE DE BREVET EUROPEEN

(21) Numéro de dépôt: 90122514.4

(22) Date de dépôt: 26.11.90

(51) Int. Cl.⁵: **H05K 7/18**

(30) Priorité: **29.11.89 FR 8915714**

(43) Date de publication de la demande:
**05.06.91 Bulletin 91/23**

(84) Etats contractants désignés:
**DE ES FR GB IT NL SE Bulletin 2**

(71) Demandeur: **ALCATEL TRANSMISSION PAR FAISCEAUX HERTZIENS A.T.F.H.**
**55, rue Greffulhe**
**F-92301 Levallois-Perret Cédex(FR)**

(72) Inventeur: **Suret, Michel**
**31, rue Tarbé des Sablons**
**F-95600 Eaubonne(FR)**
Inventeur: **Reltgen, Gérard**
**15, rue Jules Guesde**
**F-92300 Levallots-Perret(FR)**
Inventeur: **Morin, Serge**
**10 Allée Diane de Poitiers**
**F-75019 Paris(FR)**

(74) Mandataire: **Weinmiller, Jürgen et al**
**Lennéstrasse 9 Postfach 24**
**W-8133 Feldafing(DE)**

(54) **Structure verticale compatible électromagnétiquement pour système d'exploitation d'un équipement de transmission, notamment par faisceaux hertziens.**

(57) Structure verticale compatible électromagnétiquement pour système d'exploitation d'un équipement de transmission, notamment par faisceaux hertziens.

La présente invention se rapporte à une structure verticale compatible électromagnétiquement pour système d'exploitation d'un équipement de transmission, notamment par faisceaux hertziens, prévue pour contenir un ensemble de modules électriques (10), comprenant un volet supérieur (15) et un volet inférieur (16) permettant de fermer ladite structure ; ces volets étant amovibles, et s'articulant en haut et en bas de la structure autour d'axes horizontaux (17 et 18) solidaires de ladite structure, de manière à pouvoir libérer complètement l'accès aux modules (10).

FIG.2

# STRUCTURE VERTICALE COMPATIBLE ÉLECTROMAGNÉTIQUEMENT POUR SYSTÈME D'EXPLOITATION D'UN ÉQUIPEMENT DE TRANSMISSION, NOTAMMENT PAR FAISCEAUX HERTZIENS

L'invention concerne une structure verticale compatible électromagnétiquement pour système d'exploitation d'un équipement de transmission, notamment par faisceaux hertziens.

Les systèmes d'exploitation d'équipements de transmission, notamment par faisceaux hertziens numériques, utilisent de telles structures verticales placées côte à côte de manière à constituer des travées ; différents modules prenant place dans des rangées disposées les unes au-dessus des autres qui sont montées dans ces structures verticales.

L'invention a pour objet d'apporter une solution au problème posé par la nécessité de respecter les nouvelles règles de "Compatibilité électromagnétique" ou "C.E.M." (Spécification technique ST/PAB/ETR/331 du CNET (division espace et transmission radioélectrique) de novembre 1985, intitulée "Compatibilité électromagnétique des installations d'intercommunication") pour les matériels hertziens. C'est la recherche d'une certaine étanchéité aux rayonnements radioélectriques et aux décharges électrostatiques.

Elle propose, à cet effet, une structure verticale compatible électromagnétiquement pour système d'exploitation d'un équipement de transmission, notamment par faisceaux hertziens, prévue pour contenir un ensemble de modules électriques, caractérisée en ce qu'elle comprend un volet supérieur et un volet inférieur permettant de fermer ladite structure ; ces volets étant amovibles, et s'articulant en haut et en bas de la structure autour d'axes horizontaux solidaires de ladite structure, de manière à pouvoir libérer complètement l'accès aux modules.

Les caractéristiques et avantages de l'invention ressortiront d'ailleurs de la description qui va suivre, à titre d'exemple non limitatif, en référence aux figures annexées sur lesquelles :

- la figure 1 illustre un ensemble de structures verticales de l'art connu ;
- les figures 2 et 3 illustrent schématiquement un ensemble de structures verticales selon l'invention ;
- les figures 4, 5 et 6 représentent plusieurs vues de détails illustrant l'invention ;
- les figures 7 à 12 représentent des courbes illustrant les améliorations apportées par l'invention.

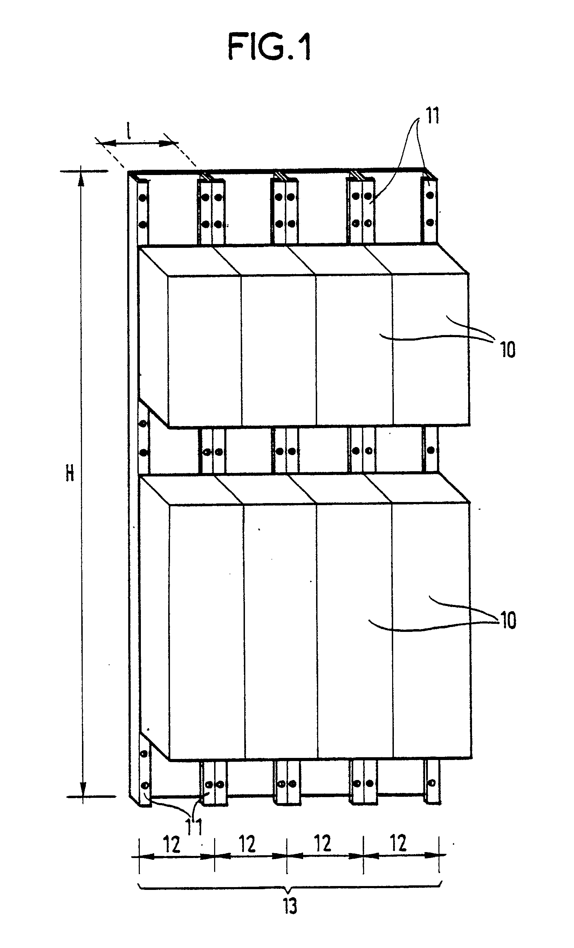

Actuellement, les matériels hertziens (grande ou moyenne capacité) se présentent sous la forme de structures verticales de largeur 1, par exemple 120 mm, pour une hauteur H, par exemple comprise entre 2 m et 2,6 m. Ainsi, comme représenté sur la figure 1, des modules électriques 10 sont fixés sur des poutres verticales 11 pour former des structures verticales 12, qui sont assemblées les unes aux autres pour constituer une station 13.

Cette organisation permet d'obtenir une modularité adaptée aux faisceaux hertziens ; car souvent une structure verticale équivaut à un canal de transmission.

Une station a une composition variable le plus souvent comprise entre quatre et seize structures verticales. Il doit être possible d'ajouter une telle structure verticale a une station existante pour ajouter un canal.

Si les modules et leurs câbles d'interconnexions n'ont pas été traité CEM cette station ne satisfait pas aux normes de compatibilité électromagnétique.

Le problème posé présente un aspect contradictoire car, d'une part, pour satisfaire aux normes de CEM il faut blinder le matériel avec une armoire métallique ayant le moins possible d'ouvertures et, d'autre part, pour favoriser la dissipation thermique il faut ouvrir au maximum pour rester en convection naturelle.

Les constructeurs ont essayé de résoudre ce problème de différentes manières.

Dans une première réalisation, le matériel en structure verticale, qui n'a pas été traité CEM, est installé dans une armoire étudiée pour contenir les rayonnements électromagnétiques.

Mais une telle réalisation présente de nombreux inconvénients :

- perte de la modularité tranche par tranche (si une armoire contient quatre structures verticales, pour cinq structures verticales il faudra fournir deux armoires) : l'encombrement est donc plus important ;
- le coût de l'armoire est élevé pour obtenir la CEM ;
- le problème thermique est mal résolu car la convection naturelle se fait mal.

Dans une seconde réalisation les modules électriques, qui sont installés sur chaque structure verticale sont traités CEM (étanchéité aux rayonnements).

Mais une telle réalisation présente les inconvénients suivants :

- le coût est très élevé puisque c'est au niveau de chaque module et des câbles d'interconnexions qu'il faut traiter le problème,
- les résultats ne sont pas très satisfaisants car si les modules peuvent être traités CEM, le câblage est difficile à protéger.

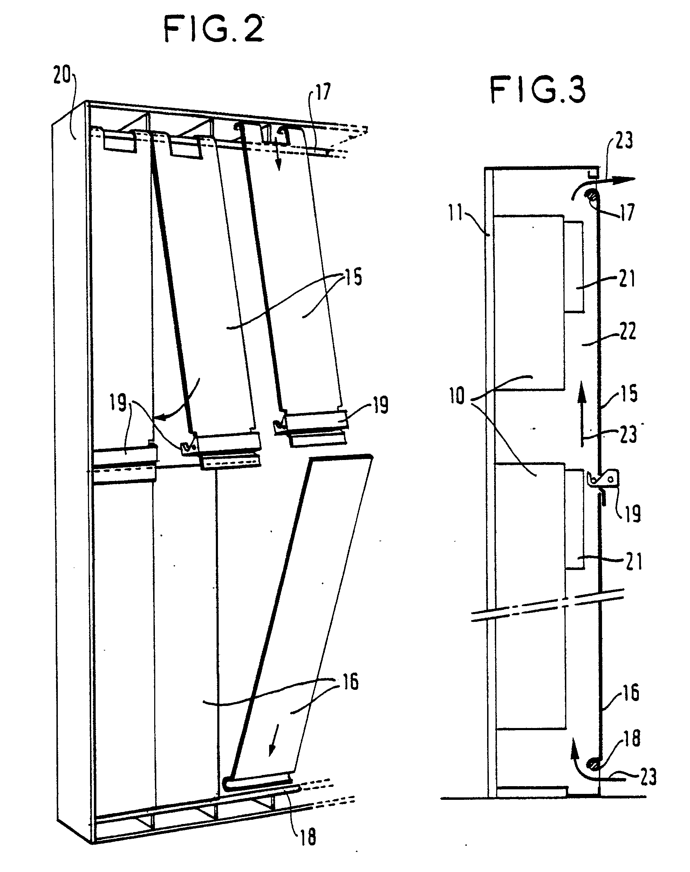

Comme représenté sur les figures 2 et 3 l'invention consiste à fermer individuellement chaque structure verticale avec un volet métallique supérieur 15 et un volet métallique inférieur 16. Ces volets sont amovibles : ils s'articulent en haut et en bas de chaque structure verticale autour d'axes horizontaux 17 et 18. La fermeture de chaque paire de volets (17, 18) s'effectue au milieu par une poignée 19 disposée en extrémité de chaque volet supérieur 15. Les extrémités latérales de l'ensemble des structures verticales disposées côte-à-côte sont fermées chacune par un panneau latéral démontable 20.

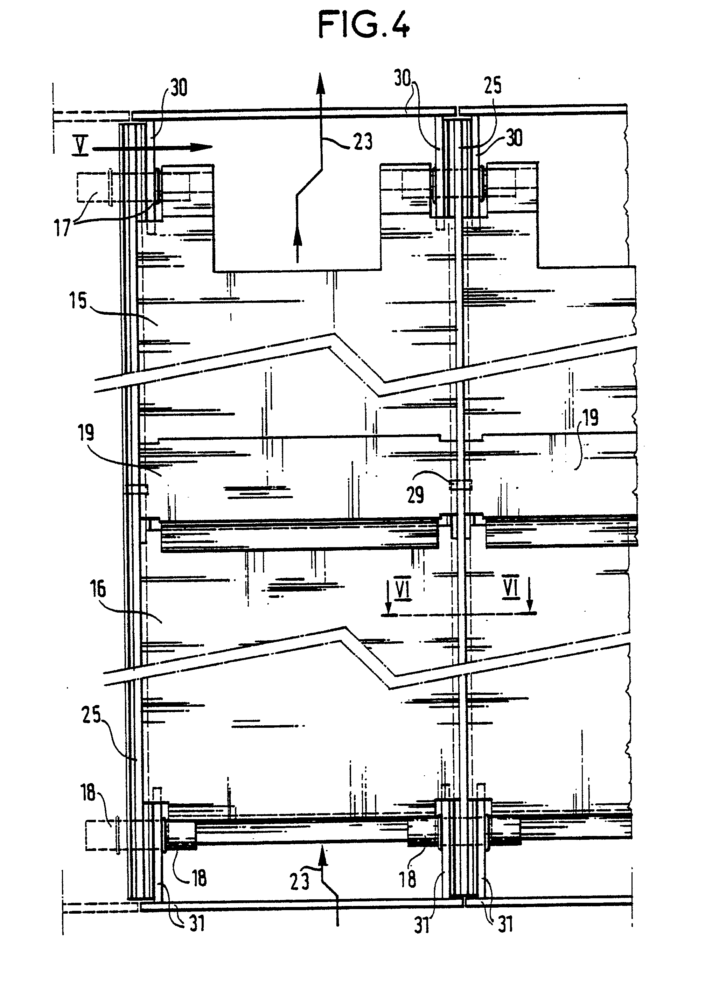

La figure 4 illustre une vue de face d'une structure verticale, les volets 15 et 16 étant en position fermée. Les axes 17 et 18 sont, dans cette représentation, formés de plusieurs petits axes horizontaux colinéaires.

Pour obtenir une meilleure étanchéité au rayonnement, chaque volet 15 (16) est muni, de chaque côté, d'un rabat à 90° 15A et 15B (16A et 16B) qui vient s'encastrer dans l'une des gorges 24 réalisées dans un profilé vertical 25, réalisé par exemple en aluminium, fixé au bâti de la structure verticale par exemple par les axes 17 et 18.

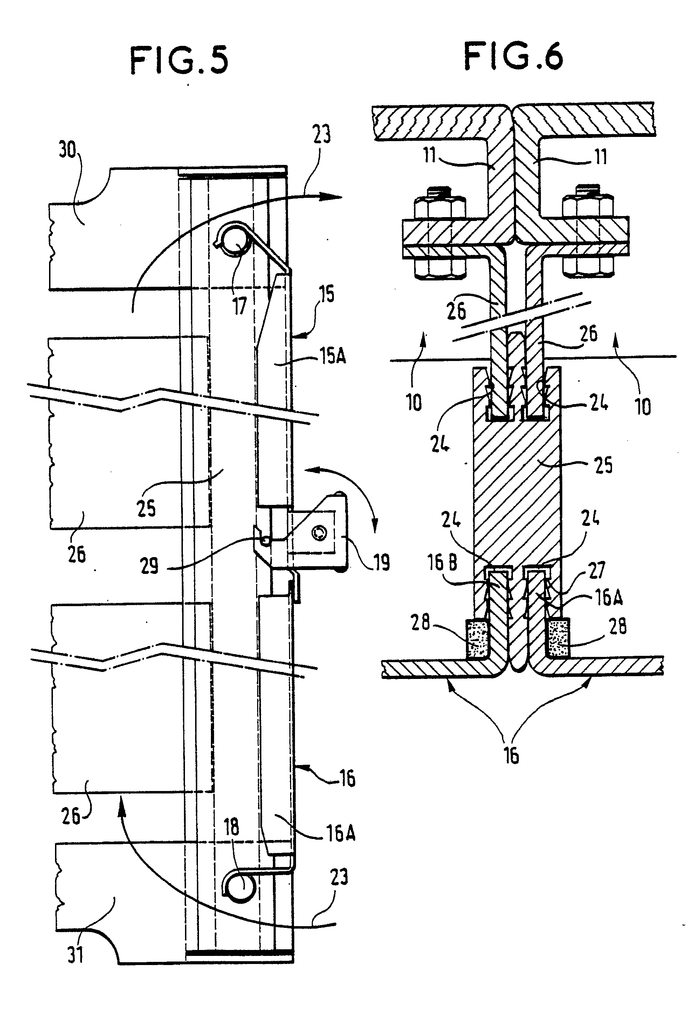

La figure 5 illustre une vue de côté d'une structure verticale suivant la flèche V de la figure 4, les volets 15 et 16 étant en position fermée, les profilés 25 avant correspondant ayant été supprimés. La poignée 19 permet l'accrochage du volet supérieur 15, dont l'extrémité inférieure vient bloquer l'extrémité supérieure du volet inférieur 16, à un axe horizontal 29 solidaire du profilé vertical 25.

De manière avantageuse, comme représenté sur la figure 6 qui est une vue en coupe VI-VI de la structure verticale représentée sur la figure 4, chaque profilé 25 présente une structure symétrique : Il est muni à chaque extrémité de deux gorges 24 verticales voisines dans lesquelles pénètrent d'un côté : les rabats des volets 15A, 15B et 16A, 16B et de l'autre côté les flancs 26 des modules 10 ; chaque gorge 24 étant par exemple pourvue d'aspérités 27 pour améliorer les contacts.

Un joint conducteur 28, disposé à la jointure entre chaque volet 15, 16 et chacun de ses rabats 15A, 15B et 16A, 16B, permet de parfaire l'étanchéité radioélectrique sur toute la hauteur des volets 15 et 16.

La fixation du profilé 25 au bâti d'une structure verticale, qui comporte une semelle haute 30 et une semelle basse 31, est réalisée par les axes 17 et 18 qui traversent le profilé 25 et les semelles haute et basse 30 et 31 de chaque structure verticale.

Ainsi l'invention permet de conserver la modularité pour réaliser les extensions de canaux et agencer les stations avec un nombre variable de structures verticales.

Les volets 15 et 16 sont amovibles et libèrent complètement l'accès aux modules.

Un espace libre (22) est réservé entre les volets et les modules, il s'y produit un effet de cheminée qui est utilisé pour la dissipation thermique (23) Des échangeurs thermiques 21, par exemple des radiateurs à ailettes, associés auxdits modules peuvent être disposés dans la "cheminée" ainsi créée.

La compatibilité électromagnétique ainsi que la résistance aux décharges électrostatiques sont très bien assurées au niveau de la station dans sa globalité (le câblage entre structures verticales est bien protégé).

Le coût de cette protection est également modulaire.

L'invention permet d'obtenir une atténuation moyenne au rayonnement de 20 dB par exemple pour un système d'exploitation mesuré dans une bande comprise entre 10 KHz et 1 GHz.

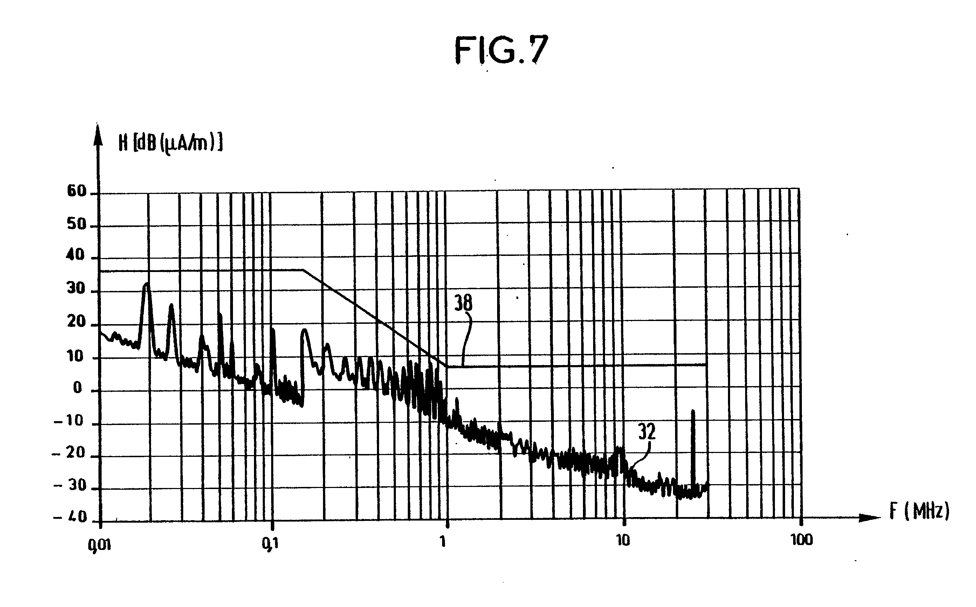

Ainsi les courbes représentées aux figures 7 à 12 permettent d'illustrer l'amélioration apportée par l'invention. Elles représentent la variation du champ magnétique H en fonction de la fréquence F ; ce qui permet de mesurer les perturbations rayonnées par le matériel, ici un faisceau hertzien 140 Mbits 6 GHz, vers l'extérieur :

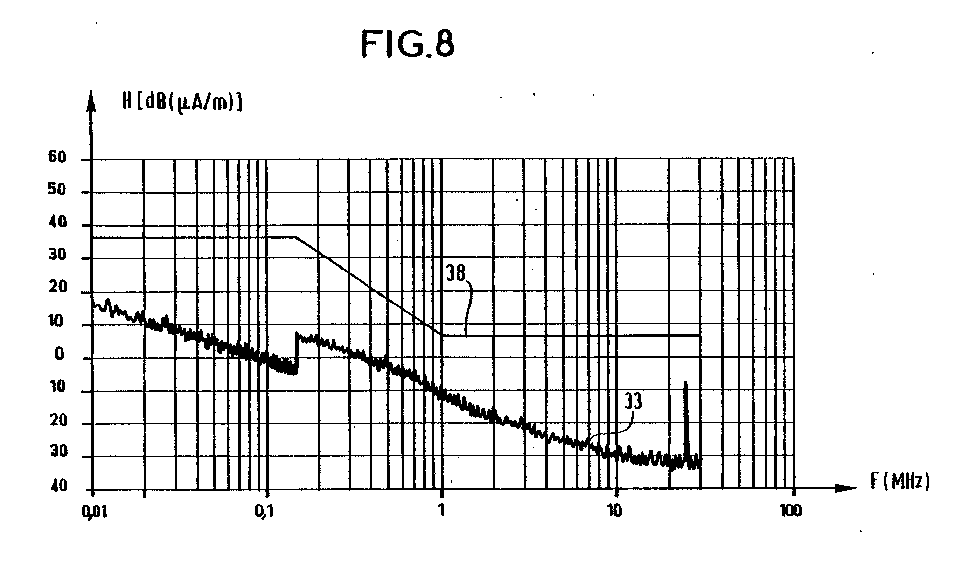

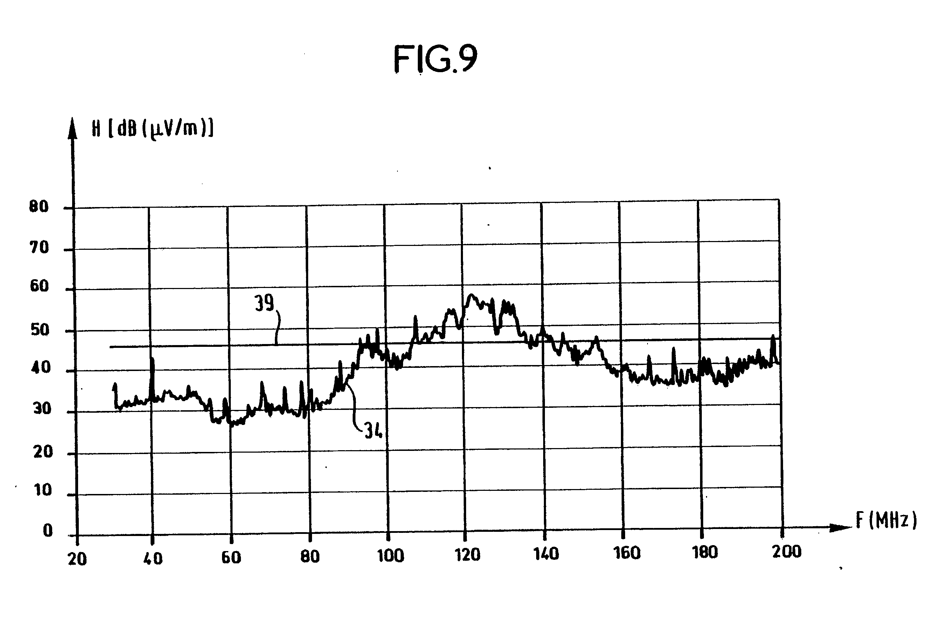

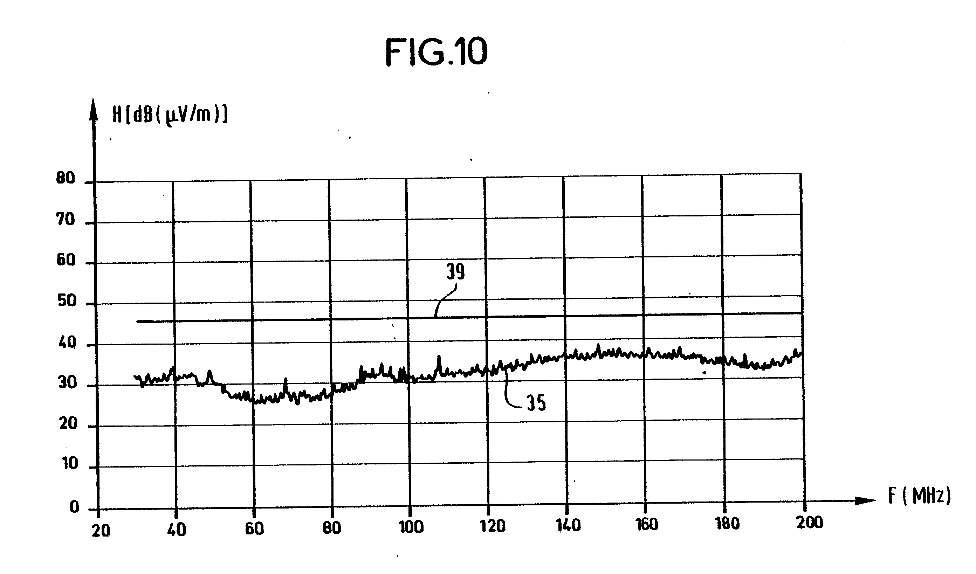

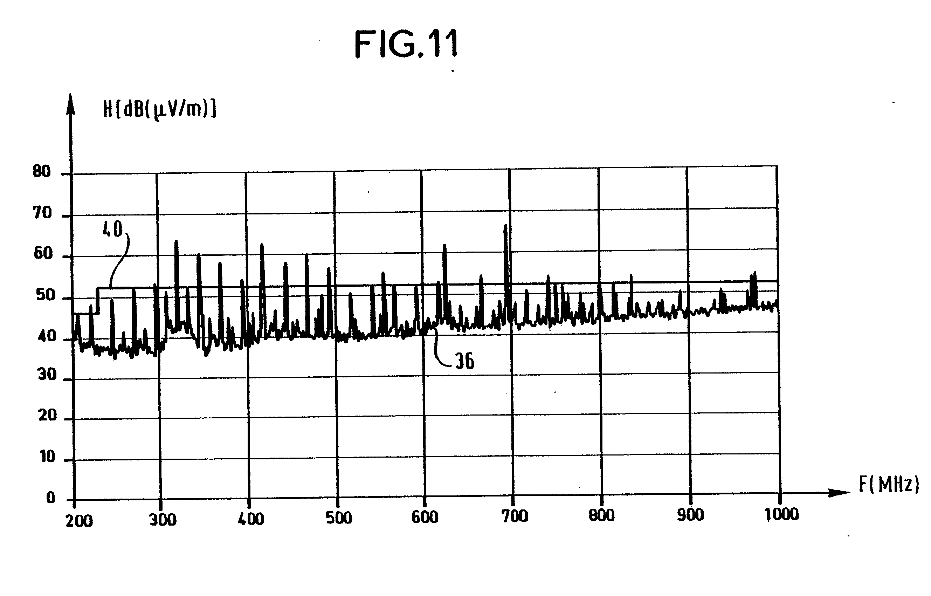

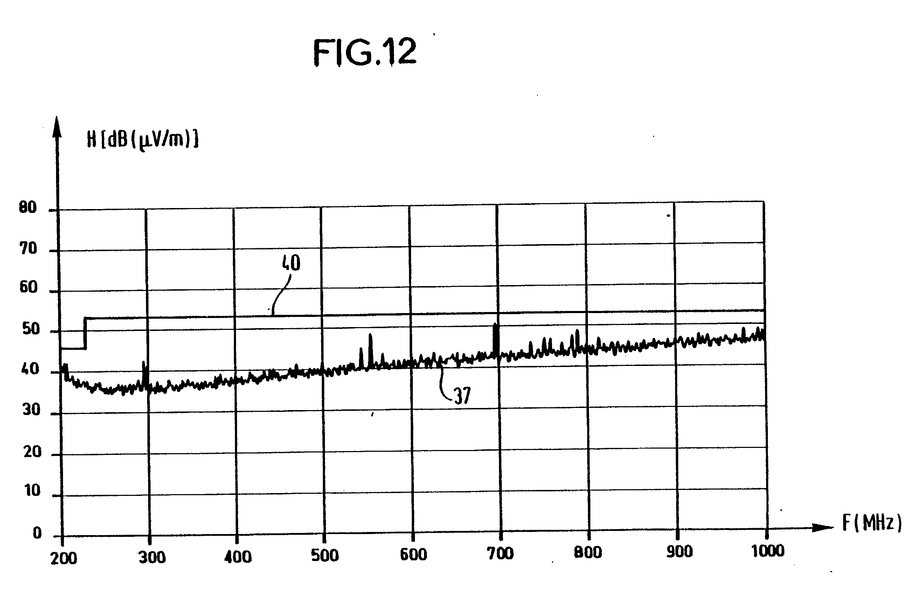

- Les deux premières courbes 32 et 33 (figures 7 et 8) correspondent à une antenne cadre fonctionnant de 10 KHz à 30 MHz sans les volets 15 et 16 de l'invention (figure 7) et avec ces volets (figure 8) ;
- les deux courbes suivantes 34 et 35 (figures 9 et 10) correspondent à une antenne biconique passant une polarisation horizontale et une polarisation verticale fonctionnant de 30 MHz à 200 MHz sans les volets 15 et 16 (figure 9) et avec ces volets (figure 10)
- les deux dernières courbes 36 et 37 (figures 11 et 12) correspondent à une antenne log-spirale passant une polarisation circulaire fonctionnant entre 200 MHz et 1 GHz sans les volets 15 et 16 (figure 11) et avec ces volets (figure 12) ;
- les gabarits des normes 38, 39 et 40 correspondant à ces différentes réalisations ayant été représentées sur les figures 7 à 12.

Il est bien entendu que la présente invention n'a été décrite et représentée qu'à titre d'exemple préférentiel et que l'on pourra remplacer ses éléments constitutifs par des éléments équivalents sans, pour autant, sortir du cadre de l'invention.

## Revendications

1.  1/ Structure verticale compatible électromagnétiquement pour système d'exploitation d'un équipement de transmission, notamment par faisceaux hertziens, prévue pour contenir un ensemble de modules électriques (10), caractérisée en ce qu'elle comprend un volet supérieur (15) et un volet inférieur (16) permettant de fermer ladite structure ; ces volets étant amovibles, et s'articulant en haut et en bas de la structure autour d'axes horizontaux (17 et 18) solidaires de ladite structure, de manière à pouvoir libérer complètement l'accès aux modules (10).

2. / Structure verticale selon la revendication 1, caractérisée en ce que les volets (15, 16) sont des volets métalliques.

3. / Structure verticale selon l'une quelconque des revendications 1 ou 2, caractérisée en ce que chaque volet (15, 16) est muni de chaque coté de rabats à 90° (15A, 15B ; 16A, 16B).

4. / Structure verticale selon la revendication 3, caractérisé en ce que chaque volet est muni d'un joint conducteur (28).

5. / Structure verticale selon la revendication 3, caractérisée en ce qu'elle comprend des profilés verticaux (25) munis de gorges dans lesquelles viennent s'encastrer d'un côté les rabats dont sont munis les volets (15, 16), et de l'autre côté les flancs (26) des modules (10).

6. / Structure verticale selon la revendication 5, caractérisée en ce que chaque profilé (25) présente une structure symétrique, et en ce qu'il est muni à chaque extrémité de deux gorges (24) verticales voisines.

7. / Structure verticale selon la revendication 6, caractérisé en ce que chaque gorge (24) est pourvue d'aspérités (27). 8/ Structure verticale selon l'une quelconque des revendications 5 à 7, caractérisée en ce que chaque profilé est en aluminium.

8. / Structure verticale selon l'une quelconque des revendications 5 à 8, caractérisée en ce qu'elle comprend un bâti comportant deux semelles haute et basse (30 et 31) et deux axes (17 et 18) qui traversent le profilé (25) et ces semelles haute et basse (30 et 31), ce qui permet d'effectuer la fixation d'un profilé (25) audit bâti.

9. / Structure verticale selon l'une quelconque des revendications 5 à 9, caractérisée en ce que la fermeture des volets (15, 16) s'effectue à l'aide d'une poignée (19) solidaire du volet supérieur (15) qui se verrouille sur un axe (29) solidaire du profilé (25).

10. / Structure verticale selon l'une quelconque des revendications précédentes, caractérisée en ce qu'un espace libre est réservé entre les volets (15, 16) et les modules (10), de telle façon qu'il s'y produise un effet de cheminée qui est utilisé pour la dissipation thermique.

11. / Station comportant un ensemble de structures verticales selon l'une quelconque des revendications précédentes, caractérisée en ce que ses deux extrémités sont fermées chacune par un panneau latéral démontable (20).

# FIG.1

# FIG.2

# FIG.3

# FIG.4

# FIG.5

# FIG.6

FIG.7

FIG.8

# FIG.9

EP 0 430 122 A1

# FIG.10

# FIG.11

EP 0 430 122 A1

# FIG.12

EP 0 430 122 A1

**Office européen des brevets**

# RAPPORT DE RECHERCHE EUROPEENNE

Numéro de la demande

**EP 90 12 2514**

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. CI.5) |
|---|---|---|---|
| Y | DE-U-1 894 754   (SIEMENS % HALSKE) <br> * pages 4 - 5 * | 1 | H <br> 05 K 7/18 |
| Y | EP-A-0 266 121   (AMERICAN TELEPHONE AND TELE-GRAPH COMPANY) <br> * colonne 3, lignes 5 - 42 * | 1 | |
| A | DE-U-8 716 277   (SIEMENS) <br> * page 3, alinéa 2 * | 1 | |
| A | DE-A-3 633 209   (SIEMENS) <br> * colonne 2, lignes 53 - 62 * | 1 | |
| A | PHILIPS TELECOMMUNICATION REVIEW. vol. 43, no. 1, avril 1985, HILVERSUM NL pages 12 - 16; K. BROKKEL-KAMP: "Electro-magnetic compatibility in Degin 400-slim" <br> * le document en entier * | 1 | |

DOMAINES TECHNIQUES RECHERCHES (Int. CI.5)

H 05 K

Le présent rapport de recherche a été établi pour toutes les revendications

| Lieu de la recherche | Date d'achèvement de la recherche | Examinateur |
|---|---|---|
| La Haye | 15 février 91 | TOUSSAINT F.M.A. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire
T : théorie ou principe à la base de l'invention

E : document de brevet antérieur, mais publié à la date de dépôt ou après cette date
D : cité dans la demande
L : cité pour d'autres raisons

&: membre de la même famille, document correspondant